(19)

Europäisches Patentamt
European Patent Office
Office européen des brevets

(11) **EP 1 811 669 A1**

(12) **EUROPEAN PATENT APPLICATION**

(43) Date of publication:
**25.07.2007 Bulletin 2007/30**

(51) Int Cl.:
**H03L 7/00** $^{(2006.01)}$

(21) Application number: **07100103.6**

(22) Date of filing: **04.01.2007**

<table>
<tr><td>

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **04.01.2006 US 325766**

(71) Applicant: **M/A-COM, INC.**
**Lowell, MA 01854 (US)**

</td><td>

(72) Inventor: **Abbasi, Saeed**
**Narberth, PA 19072 (US)**

(74) Representative: **Johnstone, Douglas Ian et al**
**Baron & Warren,**
**19 South End,**
**Kensington**
**London W8 5BU (GB)**

</td></tr>
</table>

(54) **Phase locked loop architecture with partial cascode**

(57) An apparatus including a phase locked loop circuit (1000) having a plurality of partial cascode circuits (206, 914, 924). The plurality of partial cascode circuits (206, 914, 924) may be arranged to reduce phase noise from a ground power supply voltage and a power supply voltage.

FIG. 10

EP 1 811 669 A1

**Description**

Phase-locked loop (PLL) circuits are often used to reduce noise and improve timing throughout a circuit. Timing throughout a circuit becomes particularly critical for applications requiring high-speed processing of information, such as in communications applications and video processing applications. When noise is introduced by various system components, the timing may deviate from the system clock.

Variations in power supplies may increase noise and have a significant impact on overall system performance. Several shortcomings in the conventional PLL circuit lead to a low Power Supply Rejection Ratio (PSRR) in analog cells. Lower PSRR leads to higher phase noise in the PLL, which is not desirable for processing applications. Accordingly, there is a need for a PLL circuit that provides improved PSRR.

The solution is provided by an apparatus comprising a phase locked loop circuit. The phase locked loop circuit may comprise a plurality of partial cascode circuits. The plurality of partial cascode circuits may include at least a first partial cascode circuit and a second partial cascode circuit. The first partial cascode circuit may be driven by a first bias voltage and may be connected to a ground supply voltage. The second partial cascode circuit may be driven by a second bias voltage and may be connected to a power supply voltage. The first partial cascode circuit may reduce phase noise from the ground power supply voltage. The second partial cascode circuit may reduce phase noise from the power supply voltage.

The invention will now be described by way of example with reference to the accompanying drawings in which:

**FIG. 1** illustrates one embodiment of a partial cascode differential inverter voltage controlled oscillator (VCO);

**FIG. 2** illustrates one embodiment of a VCO delay cell;

**FIG. 3** illustrates one embodiment of a partial cascode circuit;

**FIG. 4** illustrates one embodiment of an equivalent circuit of the partial cascode circuit of FIG. 3;

**FIG. 5** illustrates one embodiment of a partial cascode circuit;

**FIG. 6** illustrates one embodiment of an equivalent circuit of the partial cascode circuit of FIG. 5;

**FIG. 7** illustrates one embodiment of an equivalent circuit of the VCO delay cell of FIG. 2;

**FIG. 8** illustrates one embodiment of a time delay graph for the equivalent circuit of FIG. 8;

**FIG. 9** illustrates one embodiment of a partial cascode self-biasing multiplier;

**FIG. 10** illustrates one embodiment of a PLL circuit;

**FIG. 11** illustrates one embodiment of a linear model of the PLL circuit of FIG. 10;

**FIG. 12** illustrates one embodiment of a timing diagram; and

**FIG. 13** illustrates one embodiment of a loop filter.

Various embodiments of the present invention may be directed to a PLL circuit architecture comprising a partial cascode differential inverter VCO and/or a partial cascode self-biasing multiplier (PCSBM). In various implementations, the partial cascode differential inverter VCO and the PCSBM may be arranged to provide lower PLL noise, significant PSRR improvement, higher tolerance for lower power supply voltage without requiring a large overhead voltage penalty, increased output impedance to help matching current biasing for the VCO, and/or enhanced calibration functionality for the VCO to compensate process variation and store the result in local memory for process compensation.

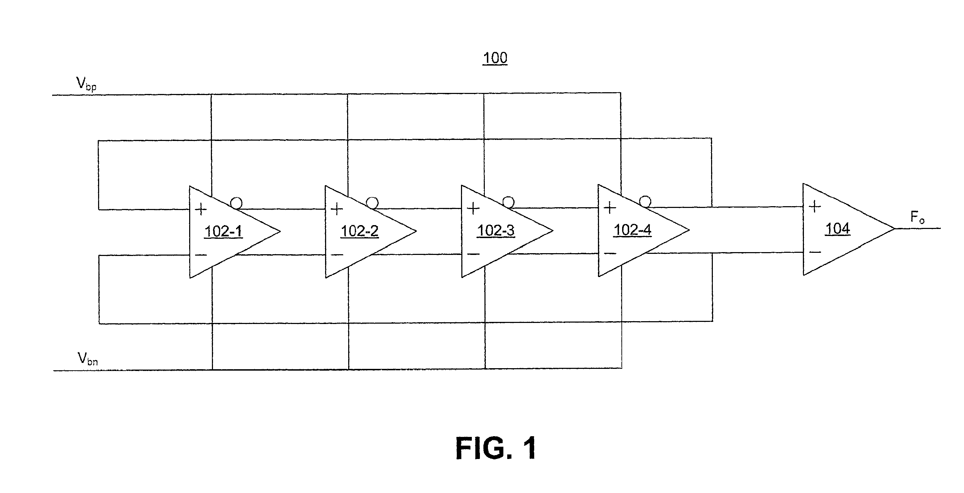

**FIG. 1** illustrates one embodiment of a partial cascode differential inverter VCO 100. In various embodiments, the differential inverter VCO 100 may be arranged to generate a desired output frequency $F_o$ in a PLL circuit architecture. As shown, the partial cascode differential inverter VCO 100 may comprise a plurality of VCO delay cells, such as VCO delay cells 102-1-4. In various implementations, bias voltages (Vbp, Vbn) may determine the amount of delay for each of the VCO delay cells 102-1-4 within the partial cascode VCO 100. The bias voltage Vbp and the bias voltage Vbn may be received, for example, from a PCSBM coupled to the partial cascode differential inverter VCO. It can be appreciated that although a limited number of VCO delay cells are shown by way of example, a greater number or fewer number of VCO delay cells may be employed for a given implementation.

In various embodiments, the VCO delay cells may be arranged such that voltage outputs of a particular VCO delay cell provide voltage inputs to a subsequent VCO delay cell. As shown in FIG. 1, for example, voltage outputs of a first VCO delay cell 102-1 provide voltage inputs to a second VCO delay cell 102-2. Voltage outputs of the second VCO delay cell 102-2 provide voltage inputs to a third VCO delay cell 102-3. Voltage outputs of the third VCO delay cell 102-3 provide the voltage inputs to a fourth VCO delay cell 102-4. Voltage outputs from the fourth VCO delay cell 102-4 are feedback as voltage inputs to the first VCO delay cell 102-1 and provided to a differential amplifier 104. The embodiments are not limited, however, to the example depicted by FIG. 1.

In various implementations, the input voltage of a low-pass filter ($V_{LPF}$) is used to control the frequency of oscillation of the partial cascode differential inverter VCO 100. Since $V_{LPF}$ is used as input to self-bias for controlling current to the partial cascode differential inverter VCO 100, all differential VCO delay cells 104-1-4 with loaded capacitance ($C_{load}$) are charged and discharged by differential current sink/source. In various embodiments, the input voltage is converted to a current in a partial cascode self-biasing circuit which is multiplied and mirrored to each fully partial cascode VCO. Each fully partial cascode differential inverter in the VCO operates in current mode, providing a much wider operating frequency range with better PSRR and high common-mode noise immunity because of the partial cascode topology on both ends without the larger overhead voltage penalty. As a result, improvement in phase noise is achieved.

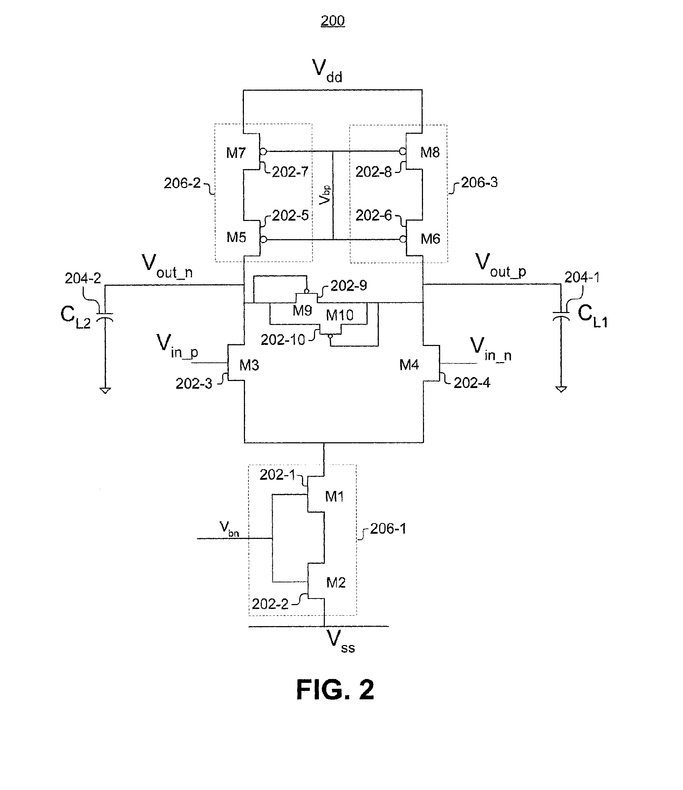

**FIG. 2** illustrates one embodiment of a VCO delay cell 200. In various embodiments, the VCO delay cell 200 may comprise one of the delay cells 102-1-4 implemented by the partial cascode differential inverter VCO 100 shown in FIG. 1. The embodiments are not limited in this context.

In various embodiments, the VCO delay cell 200 may comprise a plurality of transistors, such as transistors (M1- M10) 202-1-10, for example. Each transistor may comprise a field effect transistor (FET) such as a junction FET (JFET), a metal-oxide semiconductor FET (MOSFET), or a metal semiconductor FET (MESFET), a bipolar junction transistor (BJT), or any other type of suitable transistor. The transistors may comprise n-type or p-type semiconductor material and may be fabricated using various silicon-based processes such as MOS, complementary MOS (CMOS), bipolar, bipolar CMOS (BiCMOS), and so forth. In one embodiment, the VCO delay cell 200 may comprise n channel transistors (M1-M4) 202-1-4 and p channel transistors (M5-M10) 202-5-10. The VCO delay cell 200 also may comprise a plurality of loaded capacitances, such as first loaded capacitance ($C_{L1}$) 204-1 and second loaded capacitance ($C_{L2}$) 204-2.

In various embodiments, the VCO delay cell 200 may comprise a plurality of partial cascode circuits, such as partial cascode circuits 206-1-3, for example. As shown in FIG. 2, a first partial cascode circuit 206-1 comprises n channel transistor (M1) 202-1 and n channel transistor (M2) 202-2. A second partial cascode circuit 206-2 comprises p channel transistor (M5) 202-5 and p channel transistor (M7) 202-7, and a third partial cascode circuit 206-3 comprises p channel transistor (M6) 202-6 and p channel transistor (M8) 202-8. In this embodiment, transistor (M1) 202-1 and transistor (M2) 202-2 of the first partial cascode circuit 206-1 are driven by bias voltage Vbn. Transistor (M5) 202-5 and transistor (M7) 202-7 of the second partial cascode circuit 206-2 are driven by bias voltage Vbp. Transistor (M6) 202-6 and transistor (M8) 202-8 of the third partial cascode circuit 206-3 also are driven by bias voltage Vbp.

In various embodiments, the first partial cascode circuit 206-1 may be connected to a ground supply voltage (Vss). The second partial cascode circuit 206-2 and the third partial cascode circuit 206-3 may be connected to a power supply voltage (Vdd). In such embodiments, the partial cascode circuits 206-1-3 may implement partial cascode topology to both ends (n and p) of the VCO delay cell 200 to provide a wider operating frequency range with increased PSRR and high common-mode noise immunity without a large overhead voltage penalty. For example, the first partial cascode circuit 206-1 may reduce phase noise and provide improved PSRR with respect to the ground supply voltage (Vss). The second partial cascode circuit 206-2 and the third partial cascode circuit 206-3 may provide reduce phase noise and provide improved PSRR with respect to the power supply voltage (Vdd). In various implementations, the ground supply voltage (Vss) may be a few mV, and the power supply voltage (Vdd) may be 1.8V, for example. The embodiments are not limited, however, to the example depicted by FIG. 2.

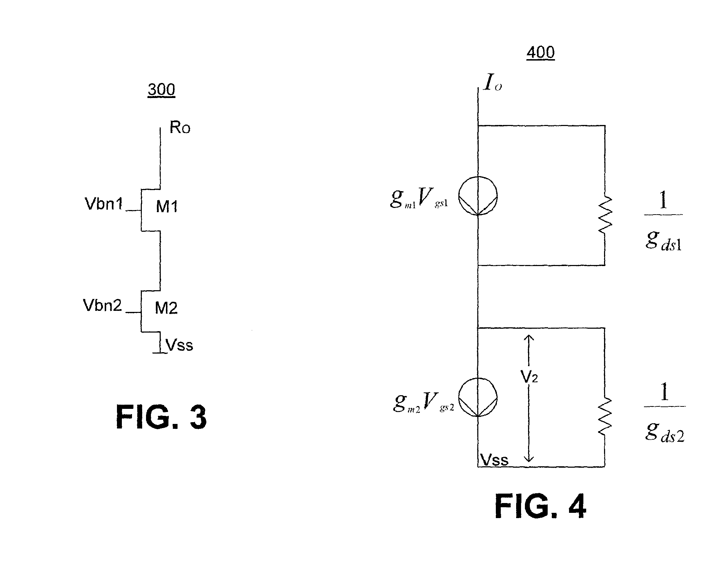

**FIG. 3** illustrates one embodiment of a partial cascode circuit 300. In various embodiments, the partial cascode circuit 300 may comprise or be implemented as the first partial cascode circuit 206-1 of the VCO delay cell 200 shown in FIG. 2. The embodiments are not limited in this context.

In one embodiment, the partial cascode circuit 300 comprises n channel transistor (M1) connected in series to n channel transistor (M2). As shown, the source of transistor (M1) is connected to the drain of transistor (M2). The gate of transistor (M1) is driven by a bias voltage Vbn1, and the gate of transistor (M2) is driven by a bias voltage Vbn2. In various embodiments, the gate of transistor (M1) and the gate of transistor (M2) may be connected together and driven by a common bias voltage Vbn at a single node.

**FIG. 4** illustrates one embodiment of an equivalent circuit 400 of the partial cascode circuit 300 shown in FIG. 3. In various embodiments, the following equations may characterize the operation of the equivalent circuit 400.

$$V_{gs1} = -V_2$$

$$V_2 = I_O * r_{2ds2}$$

$$I_O = g_{m1}(-I_O * r_{ds2}) + \frac{V_O}{r_{ds1}} - I_O \frac{r_{ds2}}{r_{ds1}}$$

$$I_O(1+g_{m1}r_{ds2}+\frac{r_{ds2}}{r_{ds1}})=\frac{V_O}{r_{ds1}}$$

$$R_O=\frac{V_O}{I_O}$$

$$R_O=\frac{(1+g_{m1}r_{ds2}+\frac{r_{ds2}}{r_{ds1}})}{r_{ds1}}\approx g_{m1}r_{ds2}r_{ds1}$$

With respect to the foregoing equations, $V_o$ is the output voltage, $I_o$ is the output current, $R_o$ is the output impedance, $g_{ml}$ is the small-signal transconductance of transistor (M1), $r_{ds1}$ is the drain-to-source channel resistance of transistor (M1), and $r_{ds2}$ is the drain-to-source channel resistance of transistor (M2). Accordingly, it can be demonstrated that the output impedance $R_o$ of the partial cascode circuit 300 may be increased by approximately the common gate voltage gain of transistor (M1) multiplied by $r_{ds2}$ without requiring a large overhead voltage penalty. Thus, the partial cascode circuit 400 may be used to reduce noise and improve PSRR, for example.

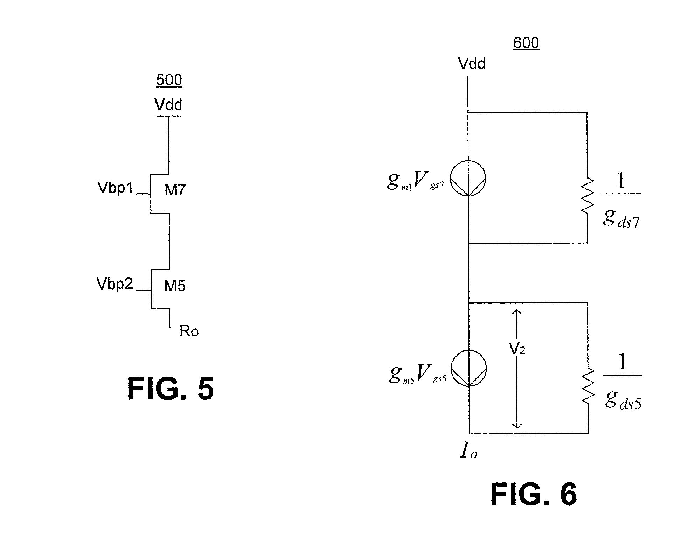

**FIG. 5** illustrates one embodiment of a partial cascode circuit 500. In various embodiments, the partial cascode circuit 500 may comprise or be implemented as the second partial cascode circuit 206-2 of the VCO delay cell 200 shown in FIG. 2. The embodiments are not limited in this context.

In one embodiment, the partial cascode circuit 500 comprises p channel transistor (M7) connected in series to p channel transistor (M5). As shown, the source of transistor (M7) is connected to the drain of transistor (M5). The gate of transistor (M7) is driven by a bias voltage Vbp1, and the gate of transistor (M5) is driven by a bias voltage Vbp2. In various embodiments, the gate of transistor (M7) and the gate of transistor (M5) may be connected together and driven by a common bias voltage Vbp at a single node.

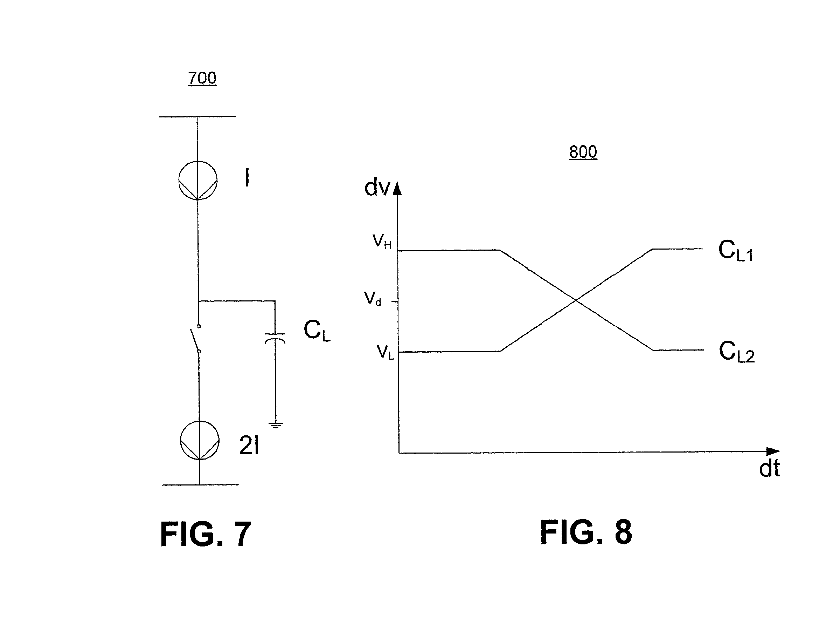

**FIG. 6** illustrates one embodiment of an equivalent circuit 600 of the partial cascode circuit 500 shown in FIG. 5. In various embodiments, the following equations may characterize the operation of the equivalent circuit 600.

$$V_{gs1}=-V_2$$

$$V_2=I_O*r_{ds5}$$

$$I_O=g_{m1}(-I_O*r_{ds5})+\frac{V_O}{r_{ds7}}-I_O\frac{r_{ds5}}{r_{ds7}}$$

$$I_O(1+g_{m5}r_{ds5}+\frac{r_{ds5}}{r_{ds7}})=\frac{V_O}{r_{ds7}}$$

4

$$R_O = \frac{V_O}{I_O}$$

$$R_O = \frac{(1 + g_{m5} r_{ds5} + \dfrac{r_{ds5}}{r_{ds7}})}{r_{ds7}} \approx g_{m5} r_{ds5} r_{ds7}$$

With respect to the foregoing equations, $V_o$ is the output voltage, $I_o$ is the output current, $R_o$ is the output impedance, $g_{m5}$ is the small-signal transconductance of transistor (M5), $r_{ds5}$ is the drain-to-source channel resistance of transistor (M5), and $r_{ds7}$ is the drain-to-source channel resistance of transistor (M7). Accordingly, it can be demonstrated that the output impedance $R_o$ of the partial cascode circuit 500 may be increased by approximately the common gate voltage gain of transistor (M5) multiplied by $r_{ds7}$ without requiring a large overhead voltage penalty. Thus, the partial cascode circuit 500 may be used to reduce noise and improve PSRR, for example.

Referring again to FIG. 2, the small signal output impedance of both ends of the VCO delay cell 200 may be increased by implementing the partial cascode topology. In various implementations, the small signal impedance of the n end of the VCO delay cell 200 may be increased by the common gate voltage gain of transistor (M1), and the small signal impedance of the p end of the VCO delay cell 200 may be increase by the common gate voltage gain of transistor (M5). As a result, PSRR may be improved on both ends without requiring a large overhead voltage which can lead to a smaller common input mode range. In addition, improvement in phase noise immunity may be achieved from both the ground supply and the power supply.

As shown in FIG. 2, transistor (M3) 202-3 may receive a voltage input Vin_p, and transistor (M4) 202-4 may receive a voltage input Vin_n. In various embodiments, transistor (M5) 202-5 and transistor (M7) 202-7 may act as a current source for transistor (M3) 202-3. When transistor (M3) 202-3 is not conducting, the supplied current does not pass through transistor (M3) 202-3. Transistor (M6) 202-6 and transistor (M8) 202-8 may act as a current source for transistor (M4) 202-4. When transistor (M4) 202-4 is not conducting, the supplied current does not pass through the transistor (M4) 202-4.

In various embodiments, transistor (M3) 202-3 and transistor (M4) 202-4 may act as switches and determine the actual delay for the VCO delay cell 200. For example, the delay provided by the VCO delay cell 200 may be the duration between turning on transistor (M3) 202-3 and turning off transistor (M4) 202-4, and when the voltages Vin_p and Vin_n are equal. At this point, transistors in the next VCO delay cell may be activated, and output voltages Vout_p and Vout_n of VCO delay cell 200 may be provided as input voltages Vin_p and Vin_n to the next delay cell.

In various implementations, first loaded capacitance ($C_{L1}$) 204-1 and second loaded capacitance ($C_{L2}$) 204-2 charge and discharge to affect the voltages Vin_p and Vin_n, which rise and fall. For instance, when transistor (M3) 202-3 is on and transistor (M4) 202-4 is off, the charges on the first loaded capacitance 204-1 and the second loaded capacitance 204-2 will be affected. In various embodiments, when transistor (M3) 202-3 is on and transistor (M4) 202-4 is off, first loaded capacitance ($C_{L1}$) 204-1 charges and second loaded capacitance ($C_{L2}$) 204-2 discharges. The charging of first loaded capacitance ($C_{L1}$) 204-1 may result in Vout_p changing from low ($V_L$) to high ($V_H$) at saturation. The discharging of second loaded capacitance ($C_{L2}$) 204-2 may result in Vout_n changing from high ($V_H$) to low ($V_L$). As shown in FIG. 2, transistor (M9) 202-9 and transistor (M10) 202-10 may be arranged to provide a smaller overhead voltage such that transistor (M3) 202-3 and transistor (M4) 202-4 are prevented from moving out off the saturation mode while Vout_n is crossing Vout_p.

**FIG. 7** illustrates one embodiment of an equivalent circuit 700 of VCO delay cell 200 shown in FIG. 2. As shown, the equivalent circuit 700 comprises a loaded capacitance ($C_L$), which is charged by a current source (I) when a switch is open and discharges to provide a current source (2I) when the switch is closed. **FIG. 8** illustrates one embodiment of a time delay graph 800 for the equivalent circuit 700. The embodiments are not limited in this context.

In various embodiments, the following equations may characterise the operation of equivalent circuit 700.

Since the slop of the voltage across $C_L$ is

$$V_d = dV_{CL1} - dV_{CL2}$$

$$dV_{CL1} = \frac{I_1}{C_{L1}} dt$$

$$dV_{CL2} = \frac{I_2}{C_{L2}} dt$$

$$V_d = (V_H - dV_{CL1}) - (V_L - dV_{CL2})$$

$$V_d = (V_H - \frac{I_1}{C_{L1}} dt) - (V_L + \frac{I_2}{C_{L2}} dt)$$

$$V_d - V_H + V_L = -\frac{I_1}{C_{L1}} dt - \frac{I_2}{C_{L2}} dt$$

$$I_1 = I_2 = I$$

$$C_{L1} = C_{L2} = C$$

$$(V_H - V_L) - V_d = \frac{2I}{C} dt$$

$$dt = \frac{((V_H - V_L) - V_d)}{2} \frac{C}{I}$$

$$\frac{dt}{dVlpf} \frac{dVlpf}{dI} = \frac{((V_H - V_L) - V_d)}{2} \frac{C}{\frac{dI}{dVlpf}}$$

$$\frac{dt}{dVlpf} \frac{dVlpf}{dI} = \frac{((V_H - V_L) - V_d)C}{2\beta(V_{gs} - V_{th})}$$

In various embodiments, VCO operation may be based on the transconductance of a self-biased multiplier (SBM). For example, where $I = \dfrac{\beta}{2}\left(V_{gs} - V_{th}\right)^{2}$ and $V_{gs} = V_{1p}$ in SBM, a time constant ($t$) may determined as follows:

$$t = \frac{((V_{H} - V_{L}) - V_{d})C}{g_{m\_lpf} + g_{m\_Free\_runf}}$$

As demonstrated in the foregoing equation, the time constant ($t$) is a function of low-pass filter (LPF) transconductance ($g_{m\_lpf}$) and free run transconductance ($g_{m\_Free\_runf}$). In various embodiments, $g_{m\_Free\_rung}$ is a fixed frequency and is not a function of LPF voltage, while $g_{m\_lpf}$ is dynamic.

In various implementations, the VCO operational frequency may be based on a total time delay ($T$) comprising time constants for a plurality of VCO delay cells. For example, in a VCO comprising three VCO delay cells, the total time delay ($T$) may be determined as follows:

$$\frac{T}{2} = t_{1} + t_{2} + t_{3}$$

$$\frac{T}{2} = \frac{dt_{1}}{dVlpf}\frac{dVlpf}{dI} + \frac{dt_{2}}{dVlpf}\frac{dVlpf}{dI} + \frac{dt_{3}}{dVlpf}\frac{dVlpf}{dI}$$

$$T = \frac{N((V_{H} - V_{L}) - V_{d})C}{g_{m\_lpf} + g_{m\_Free\_runf}}$$

In various embodiments, $g_{m\_Free\_runf}$ would be multiplied by a multiplier circuit in order to have tuning condition on the VCO for N number of delay cells.

Based on the foregoing, in various embodiments, the VCO frequency of operation ($F_{VCO}$) and the gain for the VCO transfer function ($K_{VCO}$) may be expressed as follows:

$$F_{VCO} = \frac{1}{T} = \frac{\left(g_{m\_lpf} + M g_{m\_Free\_runf}\right)}{N((V_{H} - V_{L}) - V_{d})C}$$

$$K_{VCO} = \frac{dF_{VCO}}{dV_{lpf}} = \frac{\beta_{m\_lpf}}{N((V_{H} - V_{L}) - V_{d})C}$$

The embodiments, however, are not limited in this context.

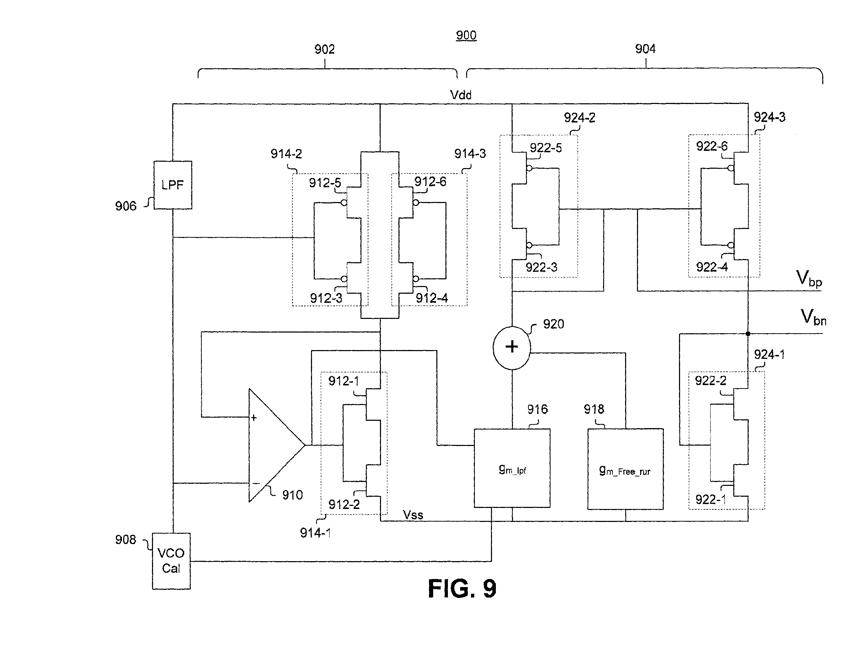

FIG. 9 illustrates one embodiment of a PCSBM 900. In various embodiments, the PCSBM 900 may be arranged to provide bias voltage Vbp and bias voltage Vbn to the partial cascode differential inverter VCO 100 of FIG. 1. For example, the PCSBM 900 may convert the input voltage from a low-pass filer (LPF) to current which is multiplied and mirrored to each fully partial cascode VCO. The embodiments are not limited in this context.

As shown in FIG. 9, the PCBM 900 may comprise bias generator portion 902 and current multiplier portion 904. In various implementations, the bias generator portion 902 may receive input from LPF 906 and provide output to current multiplier portion 904. The LPF 906 also may provide input to VCO calibration unit 908, which provides input to current multiplier portion 904.

In various embodiments, the bias generator portion 902 of the PCSBM 900 may comprise a differential amplifier 910 and plurality of transistors, such as transistors 912-1-6, for example. In one embodiment, for example, the bias generator portion 902 of the PCSBM 900 may comprise n channel transistors 912-1 and 912-2 and p channel transistors 912-3-6. Each transistor may comprise a FET, BJT, or any other type of suitable transistor.

In various embodiments, the bias generator portion 902 of the PCSBM 900 may comprise a plurality of partial cascode circuits, such as partial cascode circuits 914-1-3, for example. As shown, partial cascode circuit 914-1 comprises n channel transistor 912-1 and n channel transistor 912-2, partial cascode circuit 914-2 comprises p channel transistor 912-3 and p channel transistor 912-5, and partial cascode circuit 914-3 comprises p channel transistor 912-4 and p channel transistor 912-6.

In various embodiments, the partial cascode circuit 914-1 may be connected to a ground supply voltage (Vss). The partial cascode circuit 914-2 and partial cascode circuit 914-3 may be connected to a power supply voltage (Vdd). In such embodiments, the partial cascode circuits 914-1-3 may implement partial cascode topology to provide a wider operating frequency range with increased PSRR and high common-mode noise immunity without a large overhead voltage penalty. For example, the partial cascode circuit 914-1 may reduce phase noise and provide improved PSRR with respect to the ground supply voltage (Vss). The partial cascode circuit 914-2 and the partial cascode circuit 914-3 may reduce phase noise and provide improved PSRR with respect to the power supply voltage (Vdd). In various implementations, the ground supply voltage (Vss) may be a few mV, and the power supply voltage (Vdd) may be 1.8V, for example.

In various embodiments, the current multiplier portion 904 of the PCSBM 900 may comprise a first transconductance ($g_{m\_1pf}$) 916, a second transconductance ($g_{m\_Free\_run}$) 918, a summing unit 920, and a plurality of transistors, such as transistors 922-1-6, for example. In one embodiment, for example, the current multiplier portion 904 of the PCSBM 900 may comprise n channel transistors 922-1 and 922-2 and p channel transistors 922-3-6. Each transistor may comprise a FET, BJT, or any other type of suitable transistor.

In various embodiments, the current multiplier portion 904 of the PCSBM 900 may comprise a plurality of partial cascode circuits, such as partial cascode circuits 924-1-3, for example. As shown, partial cascode circuit 924-1 comprises n channel transistor 922-1 and n channel transistor 922-2, partial cascode circuit 924-2 comprises p channel transistor 922-3 and p channel transistor 922-5, and partial cascode circuit 924-3 comprises p channel transistor 922-4 and p channel transistor 922-6.

In various embodiments, the partial cascode circuit 924-1 may be connected to a ground supply voltage (Vss). The partial cascode circuit 924-2 and partial cascode circuit 924-3 may be connected to a power supply voltage (Vdd). In such embodiments, the partial cascode circuits 924-1-3 may implement partial cascode topology to provide a wider operating frequency range with increased PSRR and high common-mode noise immunity without a large overhead voltage penalty. For example, the partial cascode circuit 924-1 may reduce phase noise and provide improved PSRR with respect to the ground supply voltage (Vss). The partial cascode circuit 924-2 and the partial cascode circuit 924-3 may reduce phase noise and provide improved PSRR with respect to the power supply voltage (Vdd). In various implementations, the ground supply voltage (Vss) may be a few mV, and the power supply voltage (Vdd) may be 1.8V, for example.

In various implementations, the partial cascode circuits 914-1-3 and partial cascode circuits 924-1-3 of the PCSBM 900 may comprise partial cascode topology to provide a wider operating frequency range with increased PSRR and high common-mode noise immunity without a large overhead voltage penalty. In various embodiments, the bias generator portion 902 and the current multiplier portion 904 of the PCSBM 900 may be arrange to interface with each other and with a partial cascode differential inverter VCO, such as partial cascode differential inverter VCO 100. In such embodiments, the partial cascode differential inverter VCO 100 and the PCSMB 900 may implement fully partial cascode topology to ensure improved PSRR.

In various embodiments, if the voltage-controlled current sources have voltage to current linearity, then the transfer relationship may be expressed as follows:

$$I_d = g_m\left(V_{LPF}\right) + g_m\left(V_{Free\_run}\right)$$

where

$$g_{m\_SB} = \frac{dI_1}{dV_{lpf}}$$

$$V_{gs} = V_{lpf}$$

$$I = \frac{\beta}{2}(V_{gs} - V_{th})^2$$

$$g_{m\_SB} = \frac{dI_1}{dV_{lpf}}$$

$$g_{m\_SBM} = \frac{dI_1}{dV_{lpf}} + \frac{dI_2}{dV_{Free\_run}}$$

$$g_{m\_SBM} = g_{m\_lpf} + (M \times g_{m\_Free\_runf})$$

With respect to the foregoing equations, $g_{m\_SB}$ is the self-bias transconductance, and $g_{m\_SB}$ is the is the transconductance of the self-biasing multiplier transconductance. In various embodiments, the LPF voltage is converted into transconduntance $g_{m\_SBM}$ which is used to set the operational frequency of the partial cascode differential inverter VCO 100.

In various embodiments, the PCSBM 900 may provide several multiplication ranges, such as $N^2$ multiplication ranges. In one embodiment, for example, the PCSBM 900 may provide 4-bit control and 16 multiplication ranges. In various implementations, the PCSBM 900 may achieve high tolerance for process variations by calibrating the current range in the PCSBM for a specific operational frequency request. In addition, the partial cascode topology in the analog cells provides an improvement in PSRR, without requiring a large overhead voltage. As a result, the PCSBM 900 may provide lower phase noise (e.g., VCO output jitter) without a large overhead voltage penalty and significant improvement for low supply voltage process.

In various implementations, the PCSBM 900 provides the necessary bias with lower sensitivity to temperature changes, process variations, and voltage drop on the power supply, while providing better PSRR and self-calibration current setting range with lower VCO gain (KVCO). The PCSBM 900 may be arranged to provide lower PLL noise, significant PSRR improvement, higher tolerance for lower power supply voltage without requiring a large overhead voltage penalty, increased output impedance to help matching current biasing for the VCO, and/or enhanced calibration functionality for the VCO to compensate process variation and store the result in local memory for process compensation.

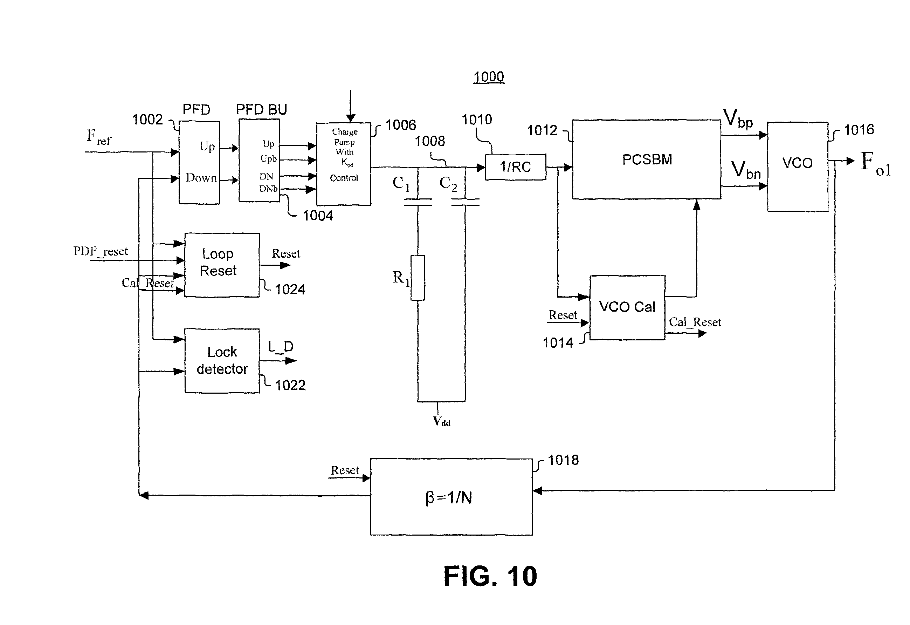

FIG. 10 illustrates one embodiment of a PLL circuit 1000. In various embodiments, the PLL circuit 1000 may comprise PFD 1002, PFD buffer 1004, charge pump 1006, loop filter 1008 including capacitors (C1, C2) and resistor (R1), LPF 1010 (e.g., 1/RC circuit), PCSBM 1012, VCO calibration unit 1014, VCO 1016, frequency divider 1018, lock detect 1020, and loop reset 1022. The embodiments are not limited in this context.

In various implementations, the PFD 1002 determines the phase and frequency difference between a reference frequency $F_{ref}$ and the divided output frequency signal $F_o/N$ from the frequency divider 1018. If a difference is detected, the PFD 1002 sends error signals Up, Down to the charge pump 1006. The duration of the error signals may depend on the amount of phase and frequency error detected by the PFD 1002.

In various embodiments, the charge pump 1006 receives the error signals Up, Down and a reference bias voltage Vbp which control the charge pump output current. The output current generated by the charge pump 1006 charges or discharges the capacitors ($C_1$, $C_2$) of loop filter 106 to a voltage level $V_{LPF}$. The voltage $V_{LPF}$ is used as a reference for the PCSBM 1012 to generate reference signals Vbp, Vbn to control the output frequency $F_o$ of the VCO 1016.

In various embodiments, the PCSBM 1012 may comprise or be implemented by the PCSBM 900 of FIG. 9, and the VCO 1016 may comprise or be implemented by the partial cascode differential inverter VCO 100 of FIG. 1. In such embodiments, the PLL circuit 1000 may be arranged to provide lower PLL noise, significant PSRR improvement, higher tolerance for lower power supply voltage without requiring a large overhead voltage penalty, increased output impedance to help matching current biasing for the VCO, and/or enhanced calibration functionality for the VCO to compensate process variation and store the result in local memory for process compensation.

In various embodiments, the charge pump 1006 may comprise a partial cascode charge pump as described in co-pending U.S. Patent Application Serial No. 11/186,000. In such embodiments, the partial cascode charge pump may implement a common current node and high output impedance architecture providing improved current matching between sink and source currents at the output. As a result, better matching in sink and source current improves phase noise and jitter as well as tolerance of process and temperature variations in matching the sink and source current outputs.

While the PLL circuit 1000 generally may be generally represented as a nonlinear system for the purpose of investigating its dynamic behaviour, linear approximation may be useful to understand the functionality and trade-offs in the PLL circuit 1000.

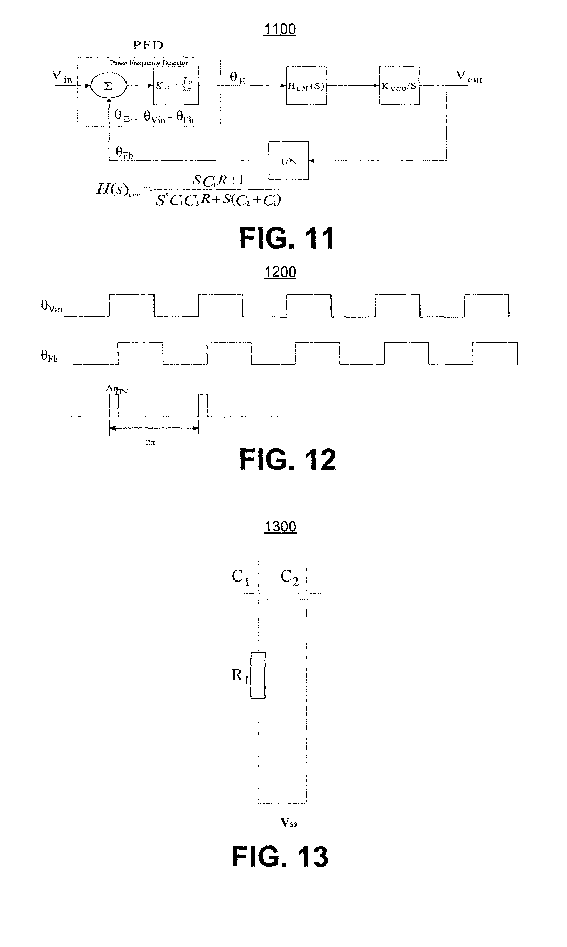

**FIG. 11** illustrates one embodiment of a linear model 1100 of PLL circuit 1000 of FIG. 10. In various embodiments, the open loop transfer function of this model is:

$$H(s) = K_{PD} K_F \left( \frac{K_{VCO}}{S} \right) \tag{1}$$

where $K_{PD}$ is phase frequency detector gain, $K_F$ is LPF gain and $K_{VCO} = \dfrac{\omega_{Max} - \omega_{Min}}{V_{Max} - V_{Min}}$ is the gain for the VCO transfer function in radians per second. $V_{Max}$ and $V_{Min}$ are maximum and minimum input control voltage for maximum and minimum $(\omega_{Max}\text{-}\omega_{Min})$ output frequency of VCO.

Substituting the gain transfer function for the LPF, $K_F = \dfrac{S c_1 R + 1}{S^2 c_1 c_2 R + S(c_1 + c_2)}$ and PFD,

$K_{PD} = \dfrac{I_P}{2\pi}$ (Amp/radian) in to (1) yields:

$$H(s) = \frac{I_P}{2\pi} \frac{K_{VCO}}{S} \frac{S C_1 R + 1}{S^2 C_1 C_2 R + S(C_1 + C_2)}$$

In order to simplify the open-loop transfer function, the expression for H(jω) may be put in a standard form as follows:

$$H(j\omega) = \frac{I_P K_{VCO}}{2\pi} \frac{j\omega C_1 R + 1}{(j\omega)^3 C_1 C_2 R + (j\omega)^2 (C_1 + C_2)}$$

where $K = \dfrac{I_P K_{VCO}}{2\pi}$ is open loop gain in radians per second.

Next, H(jω) may be written in polar form as follows:

$$H(j\omega) = \frac{K\,|\,j\omega C_1 R + 1\,|}{\left|-j\omega^3 C_1 C_2 R - \omega^2 (C_1 + C_2)\right|} \angle\left(\tan^{-1}\omega R_{c_1} - \tan^{-1}\frac{\omega R C_1 C_2}{C_1 + C_2}\right)$$

Where magnitude and phase are:

$$|H(j\omega)| = \left|\frac{I_P K_{VCO}}{2\pi} \frac{j\omega c_1 R + 1}{-j\omega^3 c_1 c_2 R + \omega^2 (c_1 + c_2)}\right|$$

$$\theta_h(\omega) = +\tan^{-1}\frac{\omega}{Z_1} - \tan^{-1}\frac{\omega}{P_3} + 180^\circ$$

$$\theta_h(\omega) = +\tan^{-1}\frac{\omega}{\dfrac{1}{c_1 R}} - \tan^{-1}\frac{\omega}{\dfrac{c_1 + c_2}{c_1 c_2 R}} + 180^\circ$$

Poles and zero of the open- loop may be defined as:

$$s^3 c_1 c_2 R + s^2 (c_1 + c_2)$$

$$P_1 = 0$$

$$P_2 = 0$$

$$P_3 = \frac{c_1 + c_2}{c_1 c_2 R}$$

$$Z_1 = \frac{1}{c_1 R}$$

Propagation delay, which is caused by the Poles and Zero, can be defined as:

$$t_{Pd} = \frac{1}{P_3} = \frac{c_1 c_2 R}{c_1 + c_2}$$

$$t_{dZ} = \frac{1}{Z_1} = c_1 R$$

The simple model closed-loop transfer function is:

$$\phi_O = (\phi_{in} - \phi_O \beta) H(S)$$

Where H (S) is the Open-Loop transfer function of the system, and $\beta$ is the loop divider:

$$\phi_O = (\phi_{in} - \phi_O \beta) K_{PD} K_F \left(\frac{K_{VCO}}{S}\right)$$

$$\phi_O \left(1 + \beta K_{PD} K_F \left(\frac{K_{VCO}}{S}\right)\right) = \phi_{in} K_{PD} K_F \left(\frac{K_{VCO}}{S}\right)$$

$$H(s) = \frac{\phi_O}{\phi_{in}} = \frac{K_{PD} K_F \left(\frac{K_{VCO}}{S}\right)}{\left(1 + \beta K_{PD} K_F \left(\frac{K_{VCO}}{S}\right)\right)}$$

Substituting the transfer function for the LPF,

$$K_F = \frac{S\,C_1 R + 1}{s^2\, C_1 C_2 R + S(C_1 + C_2)}$$

in to H(s) yields:

$$H(s) = \frac{V_o}{V_{in}} = \frac{K_{PD}\,K_{VCO}\,\dfrac{S\,C_1 R + 1}{s^2\,C_1 C_2 R + S(C_1 + C_2)}}{s + \beta K_{PD}\,K_{VCO}\,\dfrac{S\,C_1 R + 1}{s^2\,C_1 C_2 R + S(C_1 + C_2)}}$$

$$H(s) = \frac{V_o}{V_{in}} = \frac{K_{PD}\,K_{VCO}\,\dfrac{S\,C_1 R + 1}{s^2\,C_1 C_2 R + S(C_1 + C_2)}}{s + \beta K_{PD}\,K_{VCO}\,\dfrac{S\,C_1 R + 1}{s^2\,C_1 C_2 R + S(C_1 + C_2)}}$$

$$H(s) = \frac{V_o}{V_{in}} = \frac{K_{PD}\,K_{VCO}(S\,C_1 R + 1)}{s^3 c_1 c_2 R + s^2(c_1 + c_2) + \beta K_{PD}\,K_{VCO}(S\,C_1 R) + K_{VCO}\,\beta\,K_{PD}}$$

Substituting the transfer function for the PFD, $K_{PD} = \dfrac{I_P}{2\pi}$ in to H(s) yields

$$H(s) = \frac{K_{VCO}\dfrac{I_P}{2\pi}(S\,C_1 R + 1)}{s^3 c_1 c_2 R + s^2(c_1 + c_2) + \beta\,\dfrac{I_P}{2\pi}K_{VCO}(S\,C_1 R) + K_{VCO}\,\beta\,\dfrac{I_P}{2\pi}}$$

Dividing the numerator and denominator by $RC_1$ yields:

$$H(s) = \frac{K_{vco}\dfrac{I_P}{2\pi}(S c_1 R + 1)}{s^3 c_1 c_2 R 2\pi + s^2 (c_1 + c_2) 2\pi + \dfrac{I_P}{N} K_{vco}(1 + S c_1 R)}$$

The expression for H(s) may be put in standard form by dividing out the poles and zeros to yield:

$$H(s) = \frac{K_{vco} I_P (S + \dfrac{1}{c_1 R})}{c_2 2\pi (s^3 + s^2 (\dfrac{1}{c_2 R} + \dfrac{1}{c_1 R}) + s \dfrac{K_{vco}}{N} \dfrac{I_P}{2\pi N c_2} + \dfrac{I_P K_{vco}}{2\pi N R c_1 c_2})}$$

The denominator of the closed-loop transfer function may be converted to a control theory form as follows:

$$H(s) = \frac{K(S + z_{.1})}{(S + P_1)(S + P_2)(S + P_3)} = \frac{K(S + z_{.1})}{(S + P_1)(S + \alpha - j\beta)(S + \alpha + j\beta)}$$

$$H(s) = \frac{K(S + z_{.1})}{(S + P_1)(s^2 + 2S\alpha + (\alpha^2 + \beta^2))}$$

$$H(s) = \frac{K(S + z_{.1})}{(S + P_1)(S + 2\zeta \omega_n S + \omega_n^2)} = \frac{K z_{.1}(\dfrac{S}{z_{.1}} + 1)}{P_1(\dfrac{S}{P_1} + 1)\omega_n^2((\dfrac{S}{\omega_n})^2 + 2\zeta \dfrac{S}{\omega_n} + 1)}$$

The phase as function of $\omega$ may be defined as follows:

$$\theta(\omega) = \tan^{-1}\frac{\omega}{z_1} - \tan^{-1}\frac{\omega}{P_1}\tan^{-1}\frac{2\zeta\dfrac{\omega}{\omega_n}}{1 - \dfrac{\omega}{\omega_n}}$$

where $\omega_n = \alpha^2 + \beta^2$ is the corner frequency of the quadratic factor and Zeta $\zeta = \dfrac{\omega_n^2}{2\omega_n}$ is the damping coefficient of the quadratic term.

**FIG. 12** illustrates one embodiment of a timing diagram 1200. As shown, it may be assumed that the input phase $\theta_{Vin}$ and the output (feedback) phase $\theta_{Fb}$ change little in any given frequency, where $\theta_{Fb} = \theta_{Vout/N}$. The embodiments are not limited in this context.

**FIG. 13** illustrates one embodiment of a loop filter 1300. In various embodiments, small signal analysis may be used to calculate values of $C_1$, $C_2$ and R. In such analysis, the average charge which is follow in to the low-pass filter (e.g., LPF 1010 of FIG. 10) can be defined as:

$$I_{avg} = \frac{\Delta\phi_{IN}}{2\pi} I_{ch}$$

where:

$$I_{avg} = K_{pd}\left(\phi_{IN2} - \phi_{IN1}\right) = K_{pd}\Delta\phi_{IN}$$

and

$$K_{pd} = \frac{I_{ch}}{2\pi}$$

To simplify the close loop transfer function, $C_2$ is assumed to equal to 0, and the expression for H(j$\omega$) is put in standard form as follows:

$$H(j\omega) = \frac{K_{PD}K_{VCO}(SC_1R+1)}{S^2 + S\dfrac{K_{PD}K_{VCO}R}{N} + \dfrac{K_{PD}K_{VCO}}{NC_1}}$$

Next, $C_1$ can be defined by $\omega_n = \dfrac{K_{PD}K_{VCO}}{NC_1}$ for desired transient settling time of the complete loop for phase or frequency changes given by $T_1 = \dfrac{1}{\omega_n}$ and R by $\zeta = \dfrac{\omega_n}{2}RC_1$.

Finally, $C_2$ may be set to around one-twentieth the size of $C_1$ to minimize glitches. It is noted that $\omega_n$ should not be selected very close to $\omega_c$ where the delay around the sampled feedback loop causes a loss in phase margin and takes the system into the unstable condition. Accordingly, $\omega_n \leq \dfrac{\omega_c}{10}$ should be maintained in order have good phase margin.

With respect to the loop-filter, $C_2$ initially may be assumed equal to zero to simplify the loop-filter transfer function. In the second order loop-filter while capacitor $C_2$ is used to keep $Icp \times R$ from causing voltage jumps at the input of VCO, $C_2$ can lead to frequency jump at the output of VCO. Most of the voltage to bring the VCO to the proper frequency is provided by the $C_1$ in the loop filter. In general, $C_2$ is set about one-twentieth of $C_1$ or more.

$$H(s)_{LPF} = (R + \frac{1}{SC_1}) \| (\frac{1}{SC_2}) = (\frac{SC_1R+1}{S^2C_1C_2R+SC_2+SC_1})$$

$$V_{in\_VCO} = H(S) \times I_{PDI}$$

Where $H(s)_{LPF} = \dfrac{SC_1R+1}{S^2C_1C_2R+S(C_2+C_1)}$ poles and zero would be:

$$s^3 c_1 c_2 R + s^2 (c_1 + c_2)$$

$$P_1 = 0$$

$$P_2 = 0$$

$$P_3 = \frac{c_1+c_2}{c_1 c_2 R}$$

$$Z_1 = \frac{1}{c_1 R}$$

Propagation delay, which is caused by poles and zero can be defined as:

$$t_{Pd} = \frac{1}{P_3} = \frac{c_1 c_2 R}{c_1 + c_2},$$

it can be also called time constant.

$$t_{dZ} = \frac{1}{Z_1} = c_1 R$$

Next, H(jw) may be written in polar form as follows:

$$H(jw) = \left| \frac{\sqrt{(\omega C_1 R)^2 + 1^2}}{\sqrt{(\omega C_2 C_1 R)^2 + (\omega(C_2 + C_1))^2}} \right| \angle \tan^{-1} \omega C_1 R - \tan^{-1} \frac{c_1 c_2 R}{c_1 + c_2}$$

Where magnitude and phase of LPF are:

$$\left| H(S)_{LPF} \right| = \left| \frac{\sqrt{(\omega C_1 R)^2 + 1^2}}{\sqrt{(\omega C_2 C_1 R)^2 + (\omega(C_2 + C_1))^2}} \right|$$

$$\theta(\omega) = \tan^{-1} \omega C_1 R - \tan^{-1} \frac{c_1 c_2 R}{c_1 + c_2}$$

In various embodiments, the key equations for close loop condition may be expressed as follows:

$$K_0 = \frac{I_{CP} K_{VCO} R}{2\pi N}$$

$$\omega_n = \sqrt{\frac{I_{CP} K_{VCO}}{2\pi N C_1}}$$

$$\omega_Z = \frac{1}{C_1 R}$$

$$\omega_C = \frac{C_1 + C_2}{R C_1 C_2}$$

$$\xi = \sqrt{\frac{I_{CP} K_{VCO} R^2 C_1}{8\pi N}}$$

$$T_L = \frac{1}{\omega_n}$$

The embodiments are not limited in this context.

**Claims**

1. An apparatus comprising:

   a phase locked loop circuit (1000) comprising a plurality of partial cascode circuits (206; 914), said plurality of partial cascode circuits (206; 914) including at least a first partial cascode circuit (206-1 ; 914-1) and a second partial cascode circuit (206-2; 914-1), said first partial cascode circuit (206-1 ; 914-1) to be driven by a first bias voltage and to be connected to a ground supply voltage, said second partial cascode circuit (206-2; 914-2) to be driven by a second bias voltage and to be connected to a power supply voltage,

   wherein said first partial cascode circuit (206-1; 914-1) is to reduce phase noise from said ground power supply voltage and said second partial cascode circuit (206-2; 914-1) is to reduce phase noise from said power supply voltage.

2. The apparatus of claim 1, wherein said first partial cascode circuit (206-1 ; 914-1) is to provide an output impedance to reduce said phase noise from said ground supply voltage.

3. The apparatus of claim 1 or 2, wherein said second partial cascode circuit (206-2; 914-2) is to provide an output impedance to reduce said phase noise from said power supply voltage.

4. The apparatus of claim 1, 2 or 3, wherein said first partial cascode circuit (206-1; 914-1) comprises a plurality of n channel transistors (202-1, 202-2; 912-1, 912-2) and said second partial cascode circuit (206-2; 914-2) comprises a plurality of p channel transistors (202-5, 202-7; 912-3, 912-5).

5. The apparatus of any preceding claim, wherein said plurality of partial cascode circuits (206; 914) comprises a third partial cascode circuit (206-3; 914-3) to be driven by said second bias voltage.

6. The apparatus of claim 5, wherein said third partial cascode circuit (206-3; 914-3) comprises a plurality ofp channel transistors (202-6, 202-8; 912-4, 912-6).

7. The apparatus of any preceding claim, wherein said phase locked loop circuit comprises a voltage controlled oscillator (100) including said plurality of partial cascode circuits (206).

8. The apparatus of claim 7, wherein said voltage controlled oscillator (100) comprises a plurality of delay cells (200).

9. The apparatus of claim 8, wherein at least one of said plurality of delay cells (200) is to provide voltage outputs as voltage inputs to another one of said plurality of delay cells.

10. The apparatus of claim 7, wherein said voltage controlled oscillator (100) receives said first bias voltage and said second bias voltage from a self-biasing multiplier.

11. The apparatus of claim 7, wherein said voltage controlled oscillator (100) comprises a first loaded capacitance and a second loaded capacitance to charge and discharge to provide a delay.

12. The apparatus of any preceding claim, wherein said phase locked loop circuit comprises a self-biasing multiplier (900) including said plurality of partial cascode circuits (914).

13. The apparatus of claim 12, wherein said self-biasing multiplier (900) comprises a bias generator portion (902), said bias generator portion (902) comprising said plurality of partial cascode circuits (914).

14. The apparatus of claim 12 or 13, wherein said self-biasing multiplier (900) comprises a current multiplier portion (904), said current multiplier portion (904) comprising said plurality of partial cascode circuits (924).

15. The apparatus of any claim 12 to 14, wherein said self-biasing multiplier (900) provides said first bias voltage and said second bias voltage to a voltage controlled oscillator.

EP 1 811 669 A1

$V_{bp}$

$V_{bn}$

100

102-1

102-2

102-3

102-4

104

$F_o$

**FIG. 1**

200

$V_{dd}$

M7  202-7  $V_{bp}$  202-8  M8
206-2  202-5  202-6  206-3
M5  M6

$V_{out\_n}$  202-9  $V_{out\_p}$
204-2  M9  M10  204-1
$C_{L2}$  202-10  $C_{L1}$
$V_{in\_p}$  M3  M4  $V_{in\_n}$
202-3  202-4

202-1  M1
$V_{bn}$  206-1
202-2  M2

$V_{ss}$

# FIG. 2

EP 1 811 669 A1

**FIG. 3**

300

Ro

Vbn1 — M1

Vbn2 — M2

Vss

**FIG. 4**

400

$I_o$

$g_{m1}V_{gs1}$

$\dfrac{1}{g_{ds1}}$

$V_2$

$g_{m2}V_{gs2}$

$\dfrac{1}{g_{ds2}}$

Vss

500

Vdd

Vbp1 — M7

Vbp2 — M5

Ro

**FIG. 5**

600

Vdd

$g_{m1}V_{gs7}$   $\dfrac{1}{g_{ds7}}$

$g_{m5}V_{gs5}$   $V_2$   $\dfrac{1}{g_{ds5}}$

$I_o$

**FIG. 6**

FIG. 7

FIG. 8

EP 1 811 669 A1

FIG. 9

FIG. 10

<u>1100</u>

PFD

$$H(s)_{LPF} = \frac{SC_1R+1}{S^2C_1C_2R+S(C_2+C_1)}$$

# FIG. 11

<u>1200</u>

# FIG. 12

<u>1300</u>

# FIG. 13

**European Patent Office**

**EUROPEAN SEARCH REPORT**

Application Number

EP 07 10 0103

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 229 658 A2 (BROADCOM CORP [US]) 7 August 2002 (2002-08-07) * paragraph [0033] - paragraph [0050]; figure 3 * | 1-15 | INV. H03L7/00 |
| X | JP 2003 218694 A (SONY CORP) 31 July 2003 (2003-07-31) * the whole document * | 1-15 | |
| X | US 2004/113663 A1 (GABILLARD BERTRAND [FR]) 17 June 2004 (2004-06-17) * paragraph [0004] - paragraph [0006] * | 1-15 | |
| A | WO 03/069781 A (MOTOROLA INC [US]; FITZGIBBON MORGAN [IE]; MOORE JEREMY W [US]; BUSHEY) 21 August 2003 (2003-08-21) * page 6, line 13 - page 8, line 2; figure 2 * | 1-15 | |
| A | US 5 142 696 A (KOSIEC JEANNIE H [US] ET AL) 25 August 1992 (1992-08-25) * column 4, line 14 - column 7, line 14 * | 1-15 | TECHNICAL FIELDS SEARCHED (IPC) H03L |

The present search report has been drawn up for all claims

| Place of search | Date of completion of the search | Examiner |
|---|---|---|
| Munich | 27 April 2007 | VILLAFUERTE ABREGO |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 10 0103

This annex lists the patent family members relating to the patent documents cited in the above-mentioned European search report.
The members are as contained in the European Patent Office EDP file on
The European Patent Office is in no way liable for these particulars which are merely given for the purpose of information.

27-04-2007

| Patent document cited in search report | | | Publication date | Patent family member(s) | | Publication date |
|---|---|---|---|---|---|---|
| EP 1229658 | A2 | | 07-08-2002 | US 2003210099 A1 | | 13-11-2003 |
| | | | | US 2002149433 A1 | | 17-10-2002 |
| JP 2003218694 | A | | 31-07-2003 | NONE | | |
| US 2004113663 | A1 | | 17-06-2004 | NONE | | |
| WO 03069781 | A | | 21-08-2003 | AU 2002367623 A1 | | 04-09-2003 |
| | | | | US 2003155951 A1 | | 21-08-2003 |
| US 5142696 | A | | 25-08-1992 | NONE | | |

EPO FORM P0459

For more details about this annex : see Official Journal of the European Patent Office, No. 12/82

**EP 1 811 669 A1**

**REFERENCES CITED IN THE DESCRIPTION**

**Patent documents cited in the description**

- US 186000 A